Europäisches Patentamt

European Patent Office

Office européen des brevets

(11) Publication number: 0 498 006 A1

# EUROPEAN PATENT APPLICATION

(21) Application number: 91101578.2

(22) Date of filing: 06.02.91

(51) Int. Cl.⁵: G03F 7/20, G03F 9/00

(43) Date of publication of application:
12.08.92 Bulletin 92/33

(84) Designated Contracting States:
DE FR GB

(71) Applicant: International Business Machines Corporation
Old Orchard Road
Armonk, N.Y. 10504(US)

(72) Inventor: Korth, Hans-Erdmann
Sandbergerstrasse 34
W-7000 Stuttgart(DE)

(74) Representative: Gaugel, Heinz, Dipl.-Ing.
IBM Deutschland GmbH Schönaicher
Strasse 220
W-7030 Böblingen(DE)

(54) Superheterodyning technique in the spatial frequency domain and structure for pattern registration measurement.

(57) A superheterodyning technique in the spatial frequency domain for pattern registration measurement, a grid structure to be used in such superheterodyning techniques and a method for producing such grid structures are provided. To produce an observable fringe pattern with a fringe contrast inversion, two grid structures (7, 8) with a slightly different basic period are superposed leading to a beat modulation pattern. One of the two grid structures has a grid scale reference at its side and one of the two grid structures is supermodulated. The supermodulated grid pattern (8) modulates the beat modulation pattern and generates a virtual pointer to the reference scale. This virtual pointer is the location of the fringe contrast inversion which is determined with respect to the reference scale by human or machine vision. The supermodulated grid structure (8) is a checkerboard and the second grid structure (7) is a line grid. The pair of grid structures is engraved into the surface of an object (1) with subsequent mask processes writing the line edges as a sequence of neighboured pixels of incremental placement.

FIG. 2

The invention relates to a superheterodyning technique in the spatial frequency domain used for pattern registration measurement like overlay or alignment control, to a grid structure which can be used in such superheterodyning techniques and to a method for producing such grid structures.

To optimize the performance of printing processes, subsequent pattern transfers must register within a small fraction of the size of the smallest printable structure as e.g. known from IBM Technical Disclosure Bulletin, Vol. 32, No. 4A, September 1989, pages 464 - 466. The transfer of semiconductor structures requires a pattern registration to within a few nanometers. In the macroscopic range, a bidirectional operating needle printer, for example, must be adjusted so that forward/backward printing does not degrade the output quality.

Visual observability of the pattern registration is highly desirable. However, the direct visual approach is conflicting with the requirements for increasing precision. Vernier scales allow to read grid scales to within about 1/20 of the grid period. The reason for this is the limited capability of the observer's visual perception. The complex observation process requires to analyze the vernier scales for local symmetries and to integrate over pattern imperfections. These problems are dealt with in IBM Technical Disclosure Bulletin Vol. 31, No. 4, September 1988, pages 155 and 156. Interferometric and Moiree techniques allow to produce sinusoidally modulated fringe patterns. These can be evaluated with high precision using electrooptical measurement as described in SPIE Vol.316 High Resolution Soft X-Ray Optics (1981), pages 42 - 53, or image processing techniques.

The visual evaluation is limited again within about 1/20 of a fringe period. The observer's eye looking for textures has problems to find the accurate location of a smooth, intensity modulated fringe.

It is an object of the present invention to provide a technique and a grid structure which allow visual verification of the pattern registration, thereby achieving a maximum evaluation sensitivity better than about 1/1000 grid period.

It is another object of the invention to provide a technique and a grid structure which self-compensate skew lines and assure asymmetry control.

Another object of the invention is to provide a method for producing this grid structure with sufficient accuracy for use in the technique of the invention.

These objects and other positive effects are met by the superheterodyning technique in the spatial frequency domain, by the grid structure for use in a superheterodyning technique and by the method for producing this grid structure. The superheterodyning technique comprises the steps of superposing two grid structures, said grid structures being designed to produce an observable fringe pattern with a fringe contrast inversion wherein one of said grid structures has a grid scale reference at its side and said two grid structures have a slightly different basic period, producing a geometrically magnified beat modulation pattern, supermodulating one of said two grid structures wherein said supermodulated grid pattern modulates said beat modulation pattern and generates a virtual pointer to said reference scale, said virtual pointer being the location of said fringe contrast inversion and determining the location of said fringe contrast inversion with respect to said reference scale by observation means.

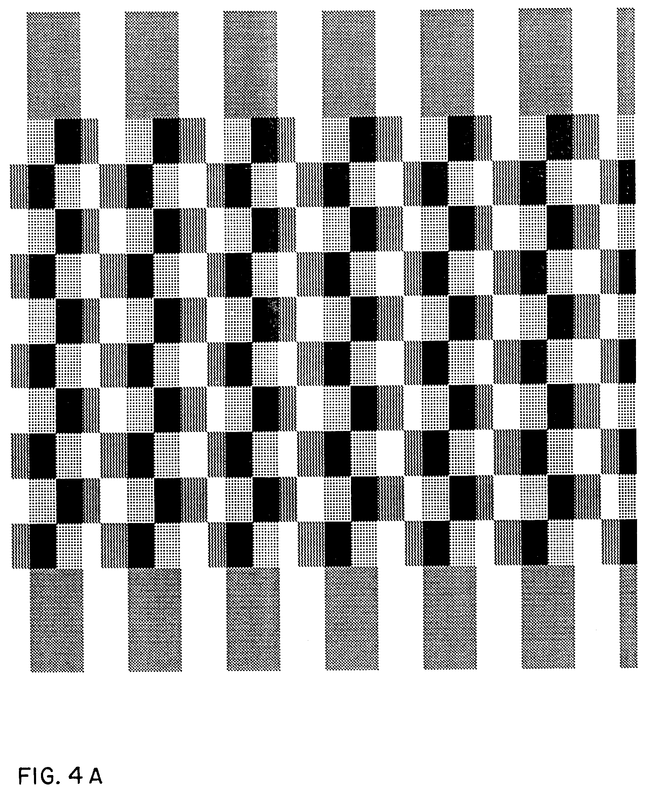

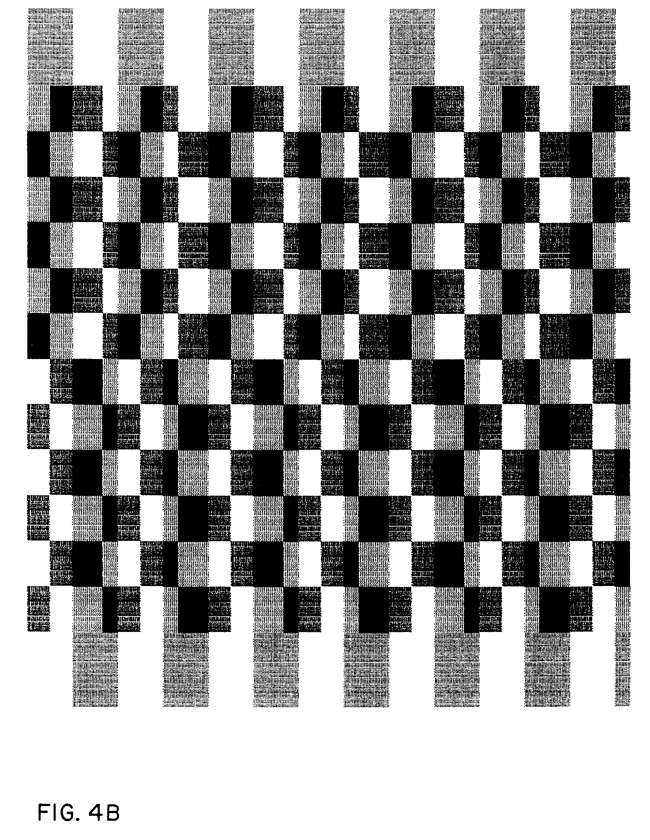

The grid structure for use in a superheterodyning technique contains an object (Figs. 4) with a pair of interleaving superimposed grid structures producing a supermodulation pattern with a fringe contrast inversion, wherein one of said grid structures has a grid scale reference at its side. One of said grid structures is a checkerboard and said checkerboard is supermodulated. The second of said grid structures is a line grid, the basic period of said line grid being slightly different to the basic period of said checkerboard.

The method for producing the grid structure comprises the steps of engraving with subsequent mask processes said pair of superimposed grid structures as amplitude or phase structures into the surface of an object, said mask process writing the line edges as a sequence of neighbored pixels of incremental placement.

The advantages offered by the present invention are that the offset magnification produced by Moiree grids is combined with a visible grid pattern that can be read against a fixed scale. A technique and a grid structure are provided which assure the accurate finding of smooth, intensity modulated fringes. Most important of all is that all these advantages are achieved with standard hardware and that white light may be used for the verification of the pattern registration.

Ways of carrying out the invention are described in detail below with reference to drawings which illustrate only specific embodiments, in which:

Fig. 1    shows a state of the art example for visual scale readout and represents a contrast inversion pointer scale;

Fig. 2    gives a schematical view of the superheterodyning technique of the present invention which yields the modulated interference pattern in Fig.3;

Figs.4    are grid structures for use in a superheterodyning technique;

Fig. 4A    is a modulated checkerboard overlaid with a line grid;
Fig. 4B    is a modulated checkerboard overlaid with a complementary split grid;
Fig. 5     gives a schematical view of the manufacturing method used to produce
           grid structures as shown in Figs. 4.

When two grid structures of slightly different frequency are superimposed, a beat or Moiree pattern becomes visible as to be seen in IBM Technical Disclosure Bulletin Vol. 23, No. 7A, December 1980, pages 2996 - 2998. A relative phase shift of the grids will be transformed into a phase shift of the beat signal and appears magnified accordingly. The location of the minimum of the beat signal may be used to read the grid offset. The location of a minimum of intensity can be judged more accurately than the location of a maximum because of the higher contrast. The location of the signal extrema does not depend on the actual shape of the beat signal, that, in reality, may deviate considerably from the ideal sine shape.

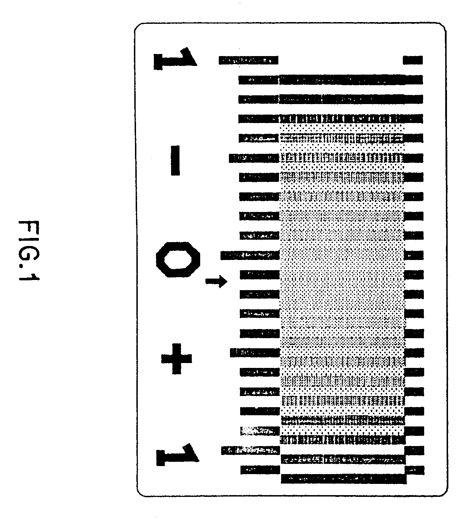

A periodic phase modulation of one or both of the grid structures will produce an amplitude modulation of the beat pattern. The amplitude of the modulation depends on the slope of the unmodulated beat signal. Across an extremum of the beat signal therefore the modulation undergoes an inversion. The modulation pattern and its inversion can be perceived quite accurately. The location of the inversion can be used as a sort of pointer for readout as can be seen in Fig. 1.

This supermodulation produces a visible texture that the eye can analyze for symmetry. The visual system seems to lock-in on the modulation pattern suppressing optical noise. This means that the whole pattern image contributes to the position readout, making optimum use of the information contained therein. In the case of low noise and good contrast, the contrast inversion can be read easily within less than 1/100 of a beat period.

The above supermodulation method can be seen as analogy in the spatial frequency domain to the superheterodyne technique used in radio communication. There, the input signal is modulated into an intermediate frequency band for low-noise, narrow-band amplification. A second demodulation transfers the output into an audio signal. Here, the optical supermodulation shall transfer the offset information or the phase of a grid of high spatial frequency into a visible intermediate spatial frequency range, where object and imaging noise have a minimum.

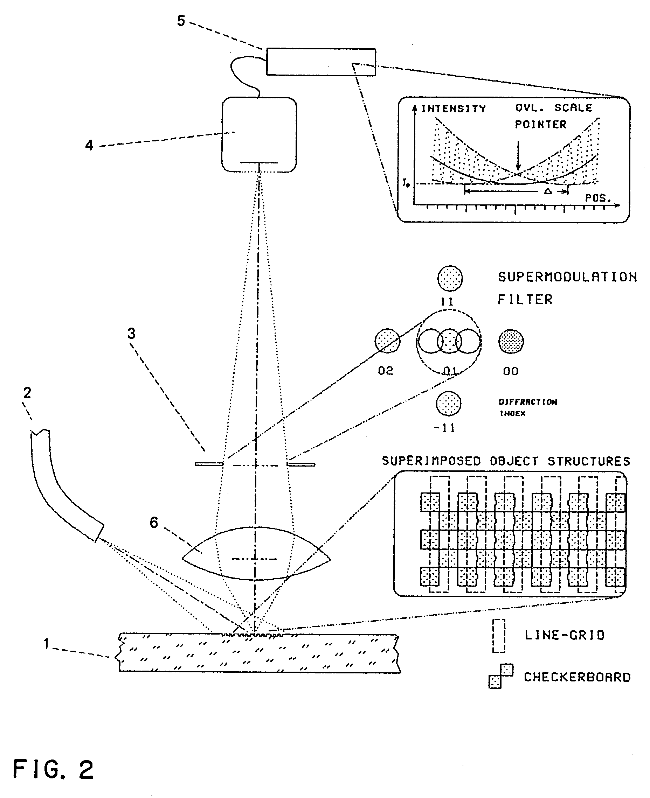

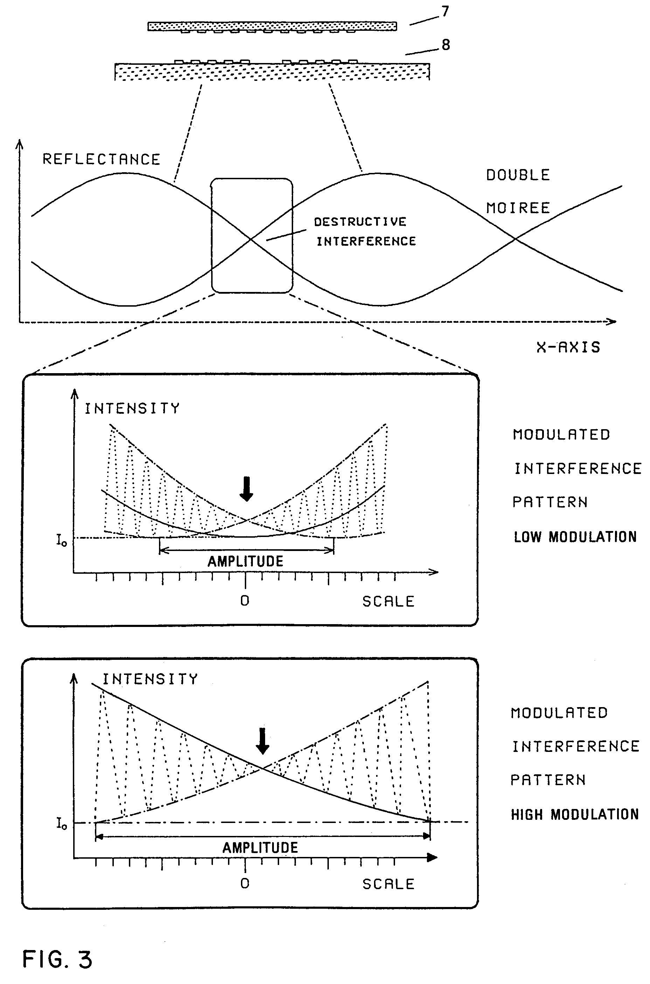

Fig. 2 gives a schematical view of the superheterodyning technique of the present invention. The object surface 1 is illuminated by lateral illumination 2. Thus, the 1st diffraction order lies within the aperture 3 of the observation means 4, the 1st diffraction order of the checkerboard being largely suppressed. The observation means 4, including human and machine vision, is connected with an image processor 5. The illumination 2 of the object 1 includes white light and polychromatic illumination and also dark-field illumination. The supermodulation or superheterodyning technique allows to select the parameters of the beat pattern and the modulation pattern to match the requirements for resolution, range and field. The basic grid period can be selected at the resolution limit of the imaging system. The period of the supermodulation must be at least twice as wide as the basic grid period and it must be wide enough to be clearly visible perceived through the optical system. To allow a reasonable range and an areal integration, a minimum of some 20 fringes should be visible across the registration field. The supermodulation amplitude should be selected to maximize the fringe visibility. A compromise has to be found between the fringe contrast and the brightness. As shown in Fig. 3, a high modulation amplitude produces a bright image with moderate fringe contrast whereas a low modulation amplitude produces high contrast fringes at the low brightness level in the vicinity of the beat modulation minimum.

A non-linear scale may be considered, too. In this case, a logarithmic scale would allow an offset proportional readout precision.

Judging the position of a pattern is more precise when picture elements are compared quantitatively and when optimized noise filtering algorithms are available. With an algorithm that simulates a lock-in amplifier and with image processing hardware the visual evaluation of supermodulated beat patterns can be emulated very efficiently, and the accuracy of visual scale readout can be improved by at least an order of magnitude. The narrow-band filtering of the supermodulation eliminates most of the signal noise. A sine curve fitted through the envelopes of the supermodulation pattern yields the pointer position which is the intersection with the x-axis, see Fig. 3, with ultimate accuracy, since the complete image field is contributing to the result.

The contrast and the visibility of the supermodulated pattern will be limited by the contrast of the beat pattern. Therefore, the background light that carries no information should be suppressed. This condition can be enforced when two beat patterns of approximately opposite phase, a mask grid 7 and a counter-phased object grid 8 with supermodulation, are superimposed within an interferometric setup as shown in Fig. 3.

Asymmetries of the optical system or the grid patterns themselves will affect the measurement precision. The symmetry requirements will be very demanding when the registration of lines shall be measured to within 1/1000 of the line width. Fig. 4 A and 4 B show grid structures suitable for use in a superheterodyning technique in the spacial frequency domain. In Fig. 4 A a pair of interleaving grid structures is superimposed. These grid structures have a high spatial frequency which is at the resolution limit of the observation means used to determine the location of the fringe contrast inversion within the measurement.

One of these grid structures is a checkerboard and the second grid structure is a line grid. The basic period of the line grid is slightly different to the basic period of the checkerboard. The checkerboard is supermodulated. This modulated checkerboard diffracts light only into the odd diffraction orders of the basic grid whereas the even diffraction orders of the checkerboard are suppressed. In a preferred embodiment, the supermodulation of the checkerboard is varying the width of its grid rows.

When a linear grid is superimposed symmetrically, no light will be diffracted in the direction parallel to the grid lines. The second grid locally breaks the symmetry of the diffraction pattern when it is superimposed to the checkerboard. When the symmetry is broken, light will be seen in this direction.

Appropriate spatial filtering like dark-field illumination will therefore allow to observe maximum contrast of the supermodulation pattern even in the case of low contrast amplitude or phase structures.

Asymmetries with an equal impact on the grid image location can be compensated. As shown in Fig. 4 B, one half of the registration field is printed with the inverted linear grid or a complementary split grid. The asymmetries produce an opposite offset for each part of the otherwise identical pattern. The offset will then be averaged out by pattern analysis.

When pattern in different planes are overlaid, the registration will be relative to the optical axis. A careful alignment of the optical system is therefore required. It can be checked easily by comparison of two measurements with a 180° rotation of the registration pattern.

Registration control is an integral constituent of photolithographic processes, especially in the submicron range which will require registration in the nanometer domain. For alignment control, grid scales on mask and wafer are superimposed to produce a beat pattern. overlay verification is done evaluating beat patterns on the wafer that were printed in subsequent photolithographic processes.

More generally, the grid structures are produced by engraving the pair of superimposed grid structures as amplitude or phase structures into the surface of an object. This is done with subsequent mask processes.

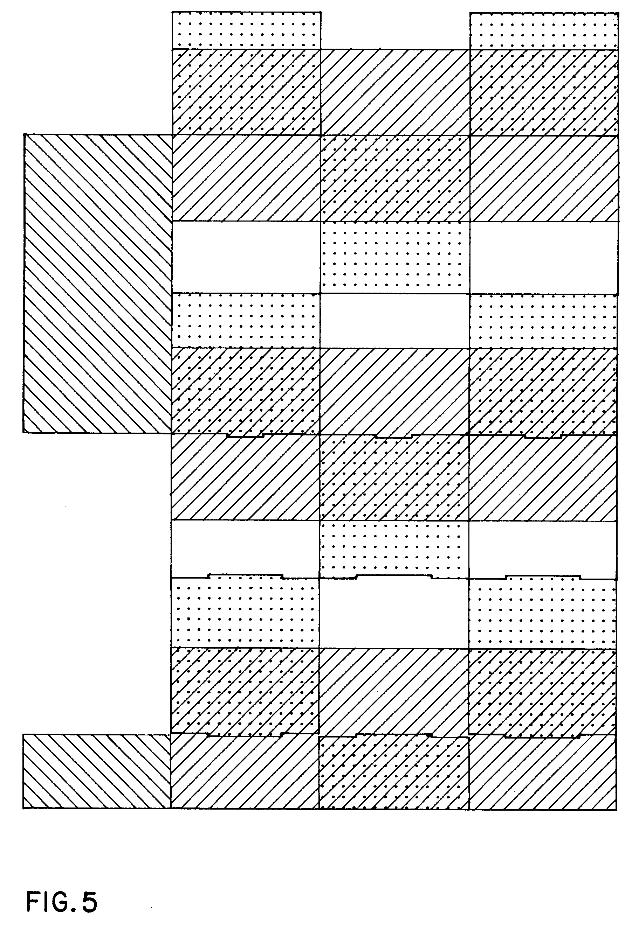

The most severe restriction for the mask linearity is the line position increment. If a grid with a period of 2 μm and a grating having 401:400 times this basic period are to be superimposed, the offset between conjugate lines on the gratings increases by 5 nm from line to line. This is significantly smaller than the incremental resolution of todays mask generators, even if a 5x mask technology is used. One way to overcome this problem is to write line elements such that they are positioned incrementally by the mask generator and the line edges form a sequence of neighbored pixels as shown in Fig. 5. The increments being small enough are averaged by the printing process assuring the mean value of the line edges to be written at the nominal location and resulting in a straight line. Random variations of the grid line width and position however should not exceed the supermodulation amplitude if they are to be averaged out.

To demonstrate the feasibility of the method with 1 micron structures on real wafers, a 5x mask was designed. The mask contains four types of supermodulated checkerboard patterns to produce a beat frequency of 1/100, 1/200, 1/400 and 1/800 of the grid constant. The mask was designed to produce average line locations within 2.5 nm on the wafer, that is 1/8 of the increment of the mask generator which is 100 nm when using the above described 5x mask.

An alternative way to write grids with maximum accuracy is to use multiple mask exposure to control the line location. A further possibility is the use of a slightly modified magnification for subsequent wafer exposures.

**Claims**

1. A superheterodyning technique in the spacial frequency domain for pattern registration measurement of an object (1)

   comprising the steps of
   - superposing two grid structures (7,8), said grid structures being designed to produce an observable fringe pattern with a fringe contrast inversion wherein
     - one of said grid structures has a grid scale reference at its side;
     - said two grid structures have a slightly different basic period;
   - producing a geometrically magnified beat modulation pattern;
   - supermodulating one of said two grid structures wherein
     - said supermodulated grid pattern (8) modulates said beat modulation pattern and generates a virtual pointer to said reference scale, said virtual pointer being the location of said fringe contrast inversion and

- determining the location of said fringe contrast inversion with respect to said reference scale by observation means (4).

2. The superheterodyning technique in the spacial frequency domain for pattern registration measurement of an object of claim 1 wherein said superposing two grid structures (7,8) includes superposing two grid structures with a high spatial frequency.

3. The superheterodyning technique in the spacial frequency domain for pattern registration measurement of an object of claim 2 wherein said high spatial frequency is at the resolution limit of the observation means (4).

4. The superheterodyning technique in the spacial frequency domain for pattern registration measurement of an object of one or more of the preceding claims 1 to 3 wherein the spatial frequency of said supermodulation of one grid structure (8) lies within the spatial transmission band of said observation means (4).

5. The superheterodyning technique in the spacial frequency domain for pattern registration measurement of an object of one or more of the preceding claims 1 to 4 wherein said determining the location of said fringe contrast inversion includes polychromatic illumination (2) of the object (1).

6. The superheterodyning technique in the spacial frequency domain for pattern registration measurement of an object of one or more of the preceding claims 1 to 4 wherein the surface of said object is smooth enough to allow dark-field illumination (2) of the object (1) during said determinig the location of said fringe contrast inversion.

7. The superheterodyning technique in the spacial frequency domain for pattern registration measurement of an object of one or more of the preceding claims 1 to 6 wherein said observation means (4) include human and machine vision.

8. A grid structure for use in a superheterodyning technique in the spacial frequency domain containing an object (Figs. 4) with a pair of interleaving superimposed grid structures producing a supermodulation pattern with a fringe contrast inversion wherein

- one of said grid structures has a grid scale reference at its side ;
- one of said grid structures is a checkerboard;
- said checkerboard is supermodulated and
- the second of said grid structures is a line grid, the basic period of said line grid being slightly different to the basic period of said checkerboard.

9. The grid structure for use in a superheterodyning technique in the spacial frequency domain of claim 8 wherein the even diffraction orders of said checkerboard are suppressed.

10. The grid structure for use in a superheterodyning technique in the spacial frequency domain of claim 8 or 9 wherein said supermodulation of said checkerboard is varying the width of the grid rows of said checkerboard along one axis.

11. The grid structure for use in a superheterodyning technique in the spacial frequency domain of one or more of the preceding claims 8 to 10 wherein said superimposed grid structures have a high spatial frequency, said high spatial frequency being at the resolution limit of the observation means (4) used to determine the location of said fringe contrast inversion.

12. A method for producing the grid structure of one or more of the preceding claims 8 to 11 comprising the steps of

- engraving with subsequent mask processes said pair of superimposed grid structures as amplitude or phase structures into the surface of an object (1),

said mask processes writing the line edges as a sequence of neighbored pixels of incremental placement.

FIG.1

FIG. 2

FIG. 3

FIG. 4 A

EP 0 498 006 A1

FIG. 4B

FIG.5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 750 836 (P.G. STEIN)<br>* abstract; figures * | 1,8 | G03F7/20<br>G03F9/00 |
| A | JOURNAL OF VACUUM SCIENCE & TECHNOLOGY: PART B.<br>vol. 6, no. 1, January 1988, NEW YORK US<br>pages 394 - 398;<br>T.NOMURA ET AL.: 'Moiré alignment technique for the mix and match lithographic system '<br>* the whole document * | 1,8 | |
| A | EP-A-15 173 (THOMSON-CSF)<br>* page 10, line 26 - page 11, line 27; figures 5,7,8 * | 1,8 | |
| A | OPTICAL ENGINEERING.<br>vol. 29, no. 7, July 1990, BELLINGHAM US<br>pages 828 - 836;<br>P. HEIMANN: 'The Color-Box alignment vernier: a sensitive lithographic alignment vernier to read at low magnification '<br>* the whole document * | 1,8 | |

**TECHNICAL FIELDS SEARCHED (Int. Cl.5 )**

G03F
G03B

The present search report has been drawn up for all claims

| Place of search | Date of completion of the search | Examiner |
|---|---|---|
| THE HAGUE | 03 OCTOBER 1991 | HERYET C.D. |

EPO FORM 1503 03.82 (P0401)